# FASCICULE DE BREVET EUROPEEN

(11) **EP 0 635 887 B1**
(45) Date de publication et mention de la délivrance du brevet: **28.04.1999**
(21) Numéro de dépôt: 94202035.5
(22) Date de dépôt: 14.07.1994
(51) Int. Cl.: H01L 27/07, H01L 29/73

(54) **Dispositif intégré associant un transistor bipolaire à un transistor à effet de champ**
Aus einem Bipolartransistor und einem Feldeffekt-Transistor bestehende integrierte Anordnung
Integrated device associating a bipolar transistor with a field effect transistor

(30) Priorité: 22.07.1993 FR 9309053
(43) Date de publication de la demande: 25.01.1995
(73) Titulaire: PHILIPS COMPOSANTS ET SEMICONDUCTEURS, 92150 Suresnes (FR); Koninklijke Philips Electronics N.V., 5621 BA Eindhoven (NL)
(72) Inventeur: Journeau, Jacques, F-75008 Paris (FR)
(74) Mandataire: Charpail, François

(56) Documents cités:
- EP-A- 0 249 088
- US-A- 4 739 386
- PESC'85 RECORD, 16TH ANNUAL IEEE POWER ELECTRONICS SPECIALISTS CONFERENCE, 24 Juin 1985, TOULOUSE, FRANCE pages 37 - 41 E.J. WILDI ET AL. '500V BIMOS Technology and its applications'

## Description

La présente invention concerne un dispositif intégré formé de l'association d'un transistor bipolaire et d'un transistor à effet de champ à jonction, comprenant :
une zone d'émetteur fortement dopée d'un premier type de conductivité, une zone de base, moins dopée que la précédente, de deuxième type de conductivité, opposé au premier type, dans laquelle la zone d'émetteur est incluse et qui comporte une extension latérale formant une grille pour le transistor à effet de champ,
une zone de collecteur formée d'une part par une portion d'une couche épitaxiale faiblement dopée du premier type de conductivité, portée par un substrat faiblement dopé du deuxième type de conductivité, et d'autre part, une région de couche enterrée fortement dopée du premier type de conductivité, s'étendant sous la zone d'émetteur,
dispositif comprenant en outre une région périphérique fortement dopée du premier type de conductivité, entourant au moins partiellement et à une certaine distance, l'ensemble de la zone de base et de son extension latérale.

Un dispositif de ce type est connu du document US-A-4 835 596. Dans ce document, il est indiqué qu'une tension de claquage de l'électrode de sortie du dispositif, de l'ordre de 40 à 60 Volts, peut être obtenue avec la structure décrite.

Toutefois, il est bien connu qu'à la suite des performances exigées pour les dispositifs intégrés, à des fréquences toujours plus élevées, on est conduit à utiliser des épaisseurs de couche épitaxiales de plus en plus minces, actuellement de l'ordre de 1 à 1,5µm seulement. Corrélativement, l'épaisseur des zones actives contenues dans la couche épitaxiale est également très petite ce qui a pour conséquence de réduire la tension de claquage BV_{CEO} des transistors NPN conventionnels, par exemple à 7 Volts pour un procédé actuel.

Dans ces conditions, le dispositif connu voit ses performances diminuer en ce qui conerne la tension de claquage, alors qu'il serait très souhaitable, au contraire, de pouvoir supporter des tensions de sortie plus élevées.

La présente invention a notamment pour but de proposer un dispositif formé de l'association d'un transistor bipolaire et d'un transistor à effet de champs, qui présente une tension de claquage de l'électrode de sortie nettement plus élevée que celle du dispositif connu, toutes autres conditions d'épaisseurs et de dopages des différentes couches restant égales par ailleurs.

A cet effet, selon la présente invention telle que revendiquée dans la revendication 1, un dispositif du genre indiqué dans le paragraphe introductif est caractérisé en ce que l'extension latérale de la zone de base comporte une ouverture dans laquelle est située une région de drain pour le transistor à effet de champ, qui est fortement dopée du premier type de conductivité, qui est entièrement entourée par ladite extension latérale et séparée de celle-ci par une distance latérale déterminée, et en ce que la région de couche enterrée, étant de forme allongée, s'étend longitudinalement au delà de l'ensemble de la zone de base et de son extension latérale jusqu'à être recouverte par ladite région périphérique, cette dernière région formant avec la région de couche enterrée la source du transistor à effet de champ.

Ainsi, par comparaison avec le dispositif connu du document précité, c'est, selon l'invention, la région de drain du transistor à effet de champ qui est entourée de tous côtés par l'extension latérale de la zone de base, alors que pour le dispositif connu, la région de drain était, au contraire, de forme annulaire, entourant l'extension latérale de la zone de base.

La disposition selon l'invention est nettement plus favorable du point de vue de la tension de claquage. En outre, selon l'invention, la position des zones acives du transistor bipolaire se trouve déportée latéralement par rapport à la position de la région de drain. La région de couche enterrée fortement dopée, formant la partie conductrice du collecteur du transistor bipolaire, fonctionne comme une partie de la source du transistor à effet de champ, partie qui est raccordée électriquement, à ses extrémités, au reste de cette source constitué par la région périphérique fortement dopée.

Le dispositif selon l'invention demeure d'une forme compacte qui est facile à incorporer dans un circuit intégré.

La tension de claquage du dispositif peut être encore accrue substantiellement dans un mode de mise en oeuvre caractérisé en ce que l'extension latérale de la zone de base est bordée par une région adjacente de même type de conductivité et plus faiblement dopée, le long du bord de l'ouverture comprenant la région de drain.

Le champ électrique développé dans la région avoisinant l'extension latérale de la zone de base, au bord de l'ouverture, se trouve réduit et la tension de claquage est donc augmentée de manière correspondante.

Selon un mode préféré de réalisation du dispositif selon l'invention, l'épaisseur de la couche épitaxiale et la concentration de dopage de cette couche sont choisies de telle sorte que cette couche épitaxiale, dans une région avoisinant ladite région adjacente plus faiblement dopée, soit entièrement désertée de porteurs de charge pour une tension déterminée appliquée à la jonction formée entre la région de drain et la grille du transistor à effet de champ, tension déterminée qui est inférieure à la tension de claquage de cette jonction.

Cette disposition est connue en soi sous le nom de condition "RESURF", qui peut se résumer en pratique au fait que le produit de l'épaisseur de la couche épitaxiale par sa concentration de dopage se situe à une valeur sensiblement comprise entre 0,8 et 1,5.10¹² atomes/cm².

Dans la région sensible au claquage, le champ électrique se trouve encore réduit, dans ces conditions, et la tension de claquage du dispositif est augmentée à nouveau.

Selon un mode de mise en oeuvre assurant une répartition très favorable du champ électrique au voisinage de la surface du semiconducteur, le dispositif selon l'invention est en outre caractérisé en ce qu'il comporte successivement au-dessus de la surface du dispositif,
une première couche isolante,
une première électrode de champ formée d'une couche conductrice en contact avec l'extension latérale de la zone de base à travèrs une première ouverture dans la première couche isolante et qui se prolonge sur la première couche isolante, au dessus de ladite région adjacente plus faiblement dopée, en direction de la région de drain et sur une distance inférieure à la moitié de ladite distance latérale,
une première partie d'une deuxième électrode de champ, conductrice, en contact avec la région de drain à travers une deuxième ouverture dans la première couche isolante et qui se prolonge latéralement sur la première couche isolante en direction de la première électrode de champ, sur une distance inférieure à la moitié de ladite distance latérale,
une deuxième couche isolante,
et une deuxième partie de la deuxième électrode de champ, conductrice, en contact avec la première partie de cette même électrode à travers une ouverture dans la deuxième couche isolante, et qui se prolonge latéralement sur le deuxième couche isolante en direction de la première électrode de champ au moins jusqu'à proximité de cette première électrode.

Une augmentation de la tension de claquage d'environ 5 Volts a été observée, en pratique, en utilisant cette dernière disposition et par comparaison avec un dispositif identique mais dépourvu d'électrodes de champs.

Lorsqu'on recherche un dispositif susceptible de débiter un courant de sortie relativement élevé, une structure avantageuse du dispositif selon l'invention est en outre caractérisée en ce que le transistor à effet de champ est constitué de deux parties, disposées symétriquement par rapport à un axe longitudinal de la région de couche enterrée, parties dont les régions homologues sont connectées électriquement en parallèle, et en ce que la région périphérique entoure totalement la zone de base et son extension latérale.

Le transistor bipolaire occupe alors une position sensiblement centrale, et les deux parties du transistor à effet de champ sont disposées de part et d'autre du transistor bipolaire.

La forme symétrique de ce dispositif offre l'avantage d'être très compacte.

Selon un autre mode de mise en oeuvre de l'invention, et en vue d'accroître encore le courant de sortie du dispositif, celui-ci est caractérisé en ce que le transistor à effet de champ est constitué d'une pluralité de cellules alignées latéralement par rapport au transistor bipolaire, la région périphérique d'une cellule ayant une partie commune avec celle de la cellule qui lui est adjacente, et les régions homologues étant connectées entre-elles.

La description détaillée qui va suivre en regard des dessins annexés, donnés à titre d'exemples non limitatifs, fera bien comprendre en quoi consiste l'invention et comment elle peut être réalisée.
La figure 1 représente un schéma électrique de l'association d'un transistor bipolaire et d'un transistor à effet de champ à jonction, schéma qui s'applique au dispositif connu de l'art antérieur ainsi qu'au dispositif selon l'invention,
la figure 2 représente une vue en coupe, et partiellement en perspective, d'un premier exemple de dispositif selon l'invention,
la figure 3 montre une vue en coupe partielle selon la ligne III-III, du dispositif représenté à la figure 2,
la figure 4 est une vue en coupe schématique et partielle d'une disposition particulière selon l'invention mettant en oeuvre des électrodes de champ,
la figure 5 est une vue schématique, en plan, d'un dispositif selon un deuxième exemple de mise en oeuvre de l'invention, et
la figure 6 est une vue schématique, en plan, d'un troisième exemple de réalisation du dispositif selon l'invention.

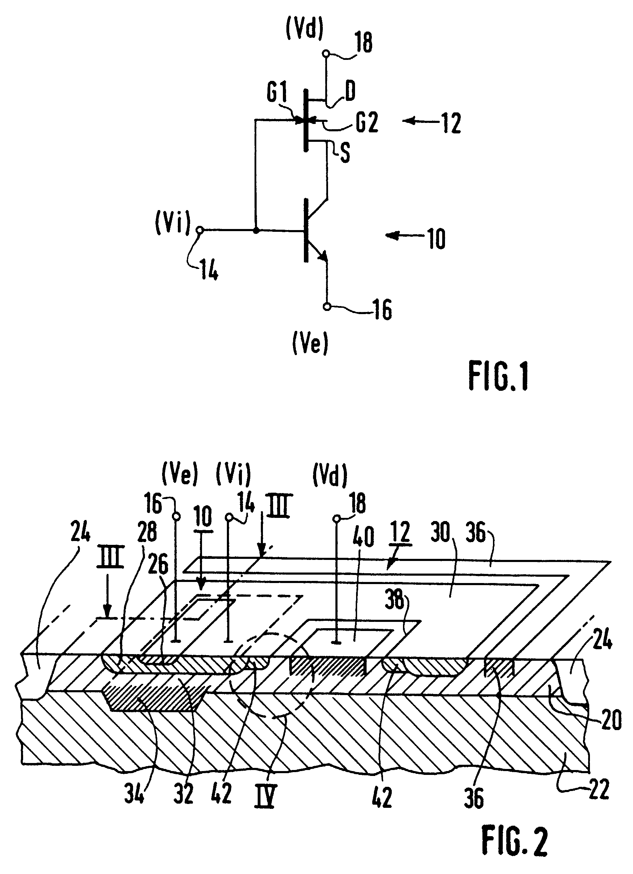

Le schéma électrique de la figure 1 représente l'association d'un transistor bipolaire NPN 10 et d'un transistor à effet de champ à jonction 12 qui est à canal N. Le collecteur du transistor bipolaire 10 est connecté à la source S du transistor à effet de champ 12, et la base du transistor bipolaire 10 est connectée à l'une des grille G1 du transistor à effet de champ 12. Une autre grille G2 du transistor à effet de champ est constituée par le substrat semiconducteur à partir duquel est construit le dispositif. La connexion entre la base du transistor bipolaire 10 et la grille G1 du transistor à effet de champ 12 constitue une borne de commande 14 pour le dispositif, laquelle borne reçoit une tension d'entrée Vi. Le trajet principal de courant est constitué du trajet émetteur/collecteur du transistor 10 en série avec le trajet source/drain du transistor 12. Une borne 16 reliée à l'émetteur du transistor 10 constitue l'une des bornes extrêmes du trajet principal de courant du dispositif tandis que l'autre borne extrême 18 est reliée au drain D du transistor à effet de champ 12, borne à laquelle est appliquée une tension Vd.

Un tel montage est connu notamment du document US-A-4 835 596 déjà cité, montage qui est susceptible d'accepter une tension Vd positive élevée, le transistor à effet de champ 12 interposant une tension drain/source importante lorsque ce transistor 12 est commandé dans un état de pincement de son canal et ainsi la tension émetteur/collecteur du transistor bipolaire 10 reste inférieure à la tension de claquage de ce transistor. Bien entendu, il est nécessaire d'observer des conditions de réalisation de ce dispositif pour qu'il fonctionne de manière convenable lorsque la grille G1 du transistor 12 est connectée à la base du transistor bipolaire 10.

Ces conditions sont telles que le transistor à effet de champ 12, du type dit à appauvrissement, ait une tension de seuil qui, en valeur absolue, est inférieure à la tension de claquage BV_{CEO} du transistor bipolaire 10. Ces conditions sont connues des spécialistes du domaine et se déduisent de données expérimentales.

La figure 2 montre en coupe très schématique un premier exemple de réalisation du dispositif selon l'invention. Conformément à cette figure, une couche épitaxiale 20 qui est mince et de type N faiblement dopée repose sur un substrat 22 de type P également faiblement dopé, l'ensemble du dispositif étant circonscrit par une région d'isolement 24 réalisée en oxyde épais par exemple. Un transistor bipolaire 10 est réalisé au moyen d'une zone d'émetteur de type N⁺26 comprise dans une zone de base 28 de type P moins dopée que la zone précédente et qui porte une extension latérale 30 formant l'une des grilles d'un transistor à effet de champ 12. Une zone de collecteur du transistor 10 est formée d'une part par une portion 32 de la couche épitaxiale 20 et d'autre part par une région de couche enterrée fortement dopée 34 de type N⁺ qui s'étend sous la zone d'émetteur 26. Le dispositif comprend également une région périphérique 36 de type N⁺, fortement dopée, qui entoure le transistor bipolaire 10 muni de l'extension latérale 30 de la zone de base, sur trois côtés, l'un de ces côté n'étant pas visible sur la figure.

Conformément à l'invention, l'extension latérale de la zone de base 30 comporte une ouverture 38 à l'intérieur de laquelle est située une région de drain 40 pour le transistor à effet de champ 12, région de drain qui est de type N⁺ fortement dopée et qui est entourée de tous côtés par ladite extension latérale 30 et qui est séparée de celle-ci par une distance latérale déterminée sensiblement constante. La région de couche enterrée 34 est de forme allongée et s'étend longitudinalement au-delà de l'ensemble de la zone de base 28 et de son extension latérale 30 jusqu'à être recouverte par la région périphérique fortement dopée 36. Ainsi cette dernière région forme avec la région de couche enterrée 34 la source du transistor à effet de champ 12.

Les bornes d'accès aux trois électrodes du dispositif ainsi que les tensions appliquées à ces bornes ont été reportées de manière très schématique avec les mêmes notations qu'à la figure 1.

Le fait que la zone de drain 40 du transistor à effet de champ 12 soit entièrement entourée par l'extension latérale 30 de la zone de base jouant le rôle de grille de ce transistor, représente une disposition très favorable pour augmenter la tension admissible Vd-Vi c'est-à-dire la tension inverse entre la région de drain 40 et l'extension latérale 30 formant une grille pour ce transistor. En effet, en appliquant une tension Vd élevée, positive, une zone déserte se développe d'une part dans le substrat 22 et d'autre part dans une portion de la couche épitaxiale 20 située sous la région de drain 40 et latéralement en direction de l'extension latérale 30 formant la grille du transistor 12. Par comparaison avec le dispositif de l'art antérieur où la région de drain entoure la grille du transistor à effet de champ, et où un contour angulaire de la grille créé des zones ou le champ électrique est plus élevé, dans le dispositif selon l'invention au contraire le contour angulaire de la zone de drain 40 ne produit pas de telles augmentations du champ électrique du fait que la zone désertée de la couche épitaxiale 20 se développe à partir de l'ouverture 38 dont le contour est concave en direction de la région de drain 40.

Selon un mode de mise en oeuvre préféré de l'invention représenté à la figure 2, l'extension latérale 30 de la zone de base est bordé par une région adjacente 42 de même type de conductivité mais plus faiblement dopée que l'extension latérale 30, le long du bord de l'ouveture 38 dans laquelle est située la région de drain 40. Le champ électrique développé lors d'une polarisation élevée de la région de drain 40 se trouve ainsi réduit et corrélativement la tension de claquage de la jonction drain/grille se trouve augmentée.

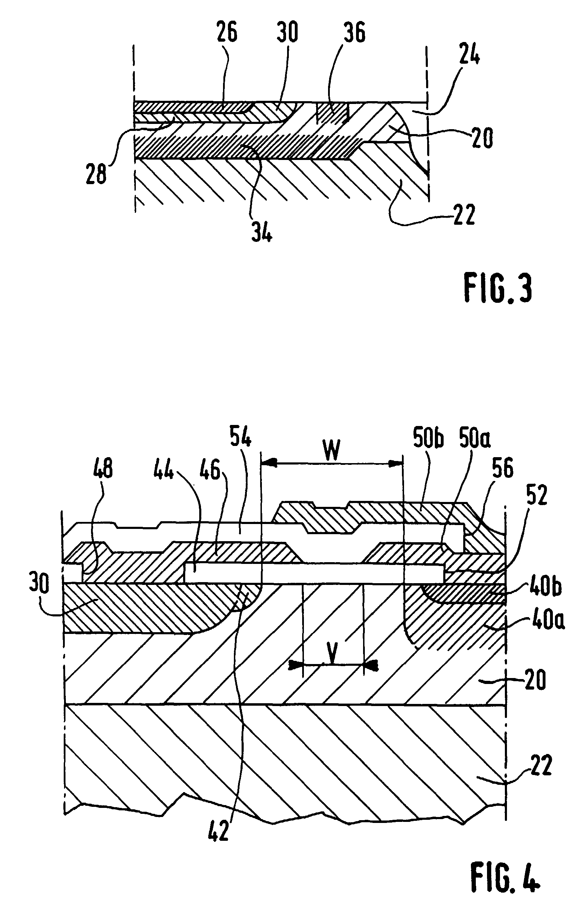

La figure 3 montre une coupe partielle du dispositif de la figure 2 selon la ligne de coupe III-III. Sur cette figure il est bien visible que la région de couche entérrée 34 fortement dopée s'étend longitudinalement jusqu'au delà de l'ensemble de la zone de base 28 et de son extension latérale 30 jusqu'à être recouverte par la région périphérique 36 fortement dopée constituant avec la région de couche enterrée 34 la source du transistor à effet de champ.

La figure 4 représente une coupe partielle fortement agrandie d'une région entourée d'une ligne en tirets portant le repère IV de la figure 2. Sur cette figure les dimensions notamment des dimensions dans le sens de l'épaisseur sont fortement exagérées pour plus de clarté. Cette figure montre l'extrémité de l'extension latérale de la zone de base 30 munie d'une région adjacente plus faiblement dopée 42 et qui est en regard de la région de drain 40a, 40b du transistor à effet de champ. Comme indiqué sur la figure, et selon un mode de réalisation pratique la région de drain est ici composée d'une partie 40a fortement dopée et relativement profonde dont la diffusion correspond à celle utilisée pour réaliser la région périphérique 36 ainsi qu'une région encore plus dopée et plus mince 40b dont la diffusion correspond à celle utilisée pour réaliser l'émetteur 26 du transistor bipolaire. Cette particularité n'est pas essentielle et la zone de drain pourrait tout aussi bien être réalisée en une seule fois, sans différence notable de résultat. La distance de séparation w entre d'une part l'extrémité de l'extension latérale de la zone de base, y compris la région adjacente plus faiblement dopée 42, et d'autre part la région de drain 40a a été appelée précédemment distance latérale entre ces deux régions.

La figure 4 illustre un exemple de mise en oeuvre de l'invention utilisant des électrodes de champ. Une première couche isolante 44 recouvre la surface du corps semiconducteur contenant le dispositif. Une première électrode de champ 46 formée par une couche conductrice métallique ou en semiconducteur polycristallin dopé est en contact avec l'extension latérale 30 à travers une première ouverture 48 réalisée dans la première couche isolante 44. Cette première électrode de champ se prolonge sur la première couche isolante au-dessus de la région adjacente plus faiblement dopée 42, en direction de la région de drain 40a sur une distance qui est inférieure à la moitié de la distance latérale w.

Une première partie 50a d'une deuxième électrode de champ 50, de même nature que la première électrode de champ 46, est en contact avec la région de drain 40b à travers une deuxième ouverture 52 dans la première couche isolante 44. Cette première partie 50a se prolonge latéralement sur la première couche isolante 44 en direction de la première électrode de champ 46 et sur une distance qui est inférieure à la moitié de la distance latérale w. Ces deux électrodes ont leurs extrémités qui se font face, séparées par une distance v qui de préférence se situe approximativement centrée sur la moitié de la distance latérale w.

L'ensemble est encore surmonté d'une deuxième couche isolante 54 qui supporte une deuxième partie 50b de la deuxième électrode de champ. Cette deuxième partie 50b est en contact avec la première partie 50a à travers une ouverture 56 dans la deuxième couche isolante 54. Elle se prolonge latéralement sur la deuxième couche isolante 54, en direction de la première électrode de champ 46 et de préférence jusqu'à l'aplomb de celle-ci.

La première électrode de champ 46 et la première partie 50a de la deuxième électrode de champ ont pour but de répartir le champ électrique à la surface du dispositif lorsque la tension Vd appliquée au drain est élevée. Une répartition optimale de ce champ électrique est réalisée lorsque l'équipotentielle de tension moitié de la tension de drain Vi se situe approximativement au milieu de la distance latérale w. En pratique, la couche de contact avec le drain du transistor à effet de champ est amenée nécessairement, au moins dans une direction, à franchir entièrement la distance latérale w. En conséquence, cette couche de contact induit par effet de champ une perturbation de la répartition de ce champ électrique qui est défavorable. C'est pourquoi on réalise dans toutes les directions une situation équivalente, telle qu'elle est indiquée à la figure 4, c'est-à-dire que la deuxième partie 50b de la deuxième électrode de champ s'étend au moins jusqu'à l'aplomb de la première électrode de champ 46, de sorte que les mêmes conditions de champ électrique sont réalisées sur le pourtour entier de la région de drain 40 du transistor à effet de champ. Il est facile de comprendre que la répartition du champ électrique à la surface du dispositif, dans la région de forme annulaire correspondant à la distance latérale w, est d'autant plus favorable que la deuxième couche isolante 54 est plus épaisse. Avec une deuxième couche isolante 54 réalisée en oxyde de silicium d'une épaisseur d'environ 600 nm, une augmentation de la tension de claquage de l'ordre de 5 V est obtenue par comparaison avec un dispositif qui n'est pas muni des électrodes de champ précédemment décrites.

### Exemple de réalisation pratique :

Une série de dispositifs selon l'invention a été élaborée dans les conditions suivantes : substrat 22 en silicium de type P. dopé à une concentration entre 1 et 2.10¹⁵ at/cm³, couche épitaxiale 20 de type N de 1,2µm d'épaisseur, dopée à une concentration de 1.10¹⁶ at/cm³, résistance spécifique par carré de l'extension latérale 30 de la zone de base = 500 Ohm/□
résistance spécifique par carré de la région adjacente 42 à l'extension latérale = 6000 Ohm/□,
distance latérale w = 6µm.

Le produit de l'épaisseur de la couche épitaxiale par sa concentration de dopage est égal à 1,2.10¹² at/cm² ce qui indique que cette couche épitaxiale est susceptible d'être désertée de porteurs de charge pour une tension Vd - Vi qui est inférieure à la tension de claquage drain-grille du transistor à effet de champ. Une répartition pratiquement optimale du champ électrique entre la grille et le drain du transistor à effet de champ est ainsi réalisée.

Les dispositifs réalisés dans ces conditions ont montré une tension de claquage de 55 Volts en moyenne lorsqu'ils sont munis des électrodes de champ précédemment décrites, contre 50 Volts pour les mêmes dispositifs mais non munis d'électrodes de champ. Par comparaison, des dispositifs construits selon la structure connue du document US-A-4 835 596, toutes autres conditions physiques étant par ailleurs identiques, ont montré une tension de claquage d'environ 30 Volts seulement. L'avantage obtenu par l'invention est donc très appréciable.

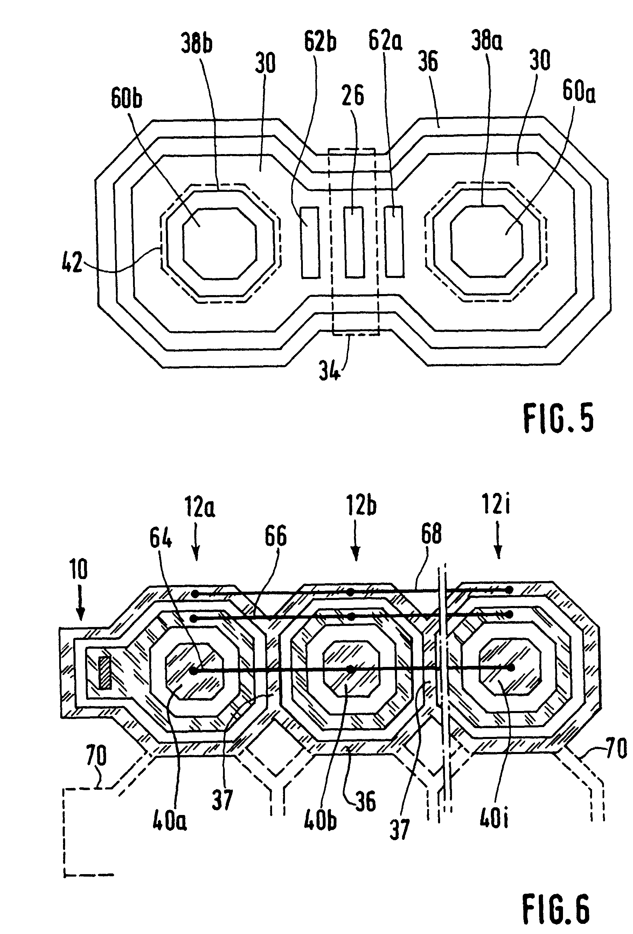

La figure 5 montre une vue en plan d'un autre exemple de réalisation d'un dispositif particulièrement avantageux lorsque ce dispositif doit pouvoir fournir un courant de sortie relativement élevé. Selon ce mode de réalisation, le transistor bipolaire a son émetteur réalisé sous le forme d'une bande centrale 26 sous laquelle est située la région de couche enterrée fortement dopée 34, représentée sur la figure en tirets. Cette région de couche enterrée 34 est de forme allongée et s'étend longitudinalement jusqu'à la région périphérique fortement dopée 36 qui entoure maintenant entièrement le dispositif. L'extension latérale de zone de base 30 s'étend de part et d'autre de la région d'émetteur 26 et porte deux ouvertures 38a et 38b pour deux régions de drain 60a et 60b du transistor à effet de champ. Ainsi celui-ci est formé de deux parties pratiquement symétriques par rapport à l'axe longitudinal de la région de couche enterrée 34. Sur la figure 5 on a représenté également deux ouvertures 62a, 62b pour le contact avec la base du transistor bipolaire ainsi qu'avec la grille du transistor à effet de champ.

La figure 6 illustre encore un autre exemple de réalisation d'un dispositif selon l'invention particulièrement indiqué lorsqu'un courant de sortie élevé est recherché.

Selon cet exemple, le transistor à effet de champ se présente sous forme d'une pluralité de cellules 12a, 12b,...12i qui sont alignées latéralement par rapport au transistor bipolaire 10. La région périphérique 36, fortement dopée, d'une cellule 12b présente une partie commune 37 avec la région périphérique de la cellule 12a qui lui est adjacente.

Les régions de drains 40a, 40b,...40i sont reliées électriquement entre elles par une bande de métallisation qui, en dehors des contacts avec les régions de drain, est isolée du reste du dispositif par une couche isolante. Une telle liaison a été indiquée de manière symbolique par une ligne 64. De la même manière, la base du transistor 10, son extension latérale dans la cellule 12a, ainsi que les régions de grille des cellules 12b,...12i sont reliées électriquement entre elles, comme indiqué par la ligne 66.

La région périphérique 36, formant la source du transistor à effet de champ peut également être pourvue d'une bande de métallisation, symbolisée sur la figure par une ligne 68, de manière à réduire la résistance de cette électrode de source.

L'aptitude de ce dispositif à délivrer un courant élevé peut encore être multipliée en associant plusieurs transistors en parallèle, de la manière indiquée par la partie 70, dessinée en tirets. Enfin, selon une variante non représentée, la pluralité de cellules du transistor à effet de champ pourrait également s'étendre de part et d'autre du transistor bipolaire 10, au lieu de ne s'étendre que d'un seul côté, comme le montre la figure 6.

## Revendications

1. Dispositif intégré formé de l'association d'un transistor bipolaire (10) et d'un transistor à effet de champ (12) à jonction, comprenant :
une zone de collecteur formée d'une part par une portion (32) d'une couche épitaxiale (20) faiblement dopée du premier type de conductivité, portée par un substrat (22) faiblement dopé du deuxième type de conductivité, et d'autre part, une région de couche enterrée fortement dopée du (34) premier type de conductivité,
une zone d'émetteur (26) fortement dopée d'un premier type de conductivité s'étendant au-dessus de la région de couche enterrée (34), une zone de base (28), moins dopée que la zone d'émetteur, de deuxième type de conductivité, opposé au premier type, dans laquelle la zone d'émetteur (26) est incluse et qui comporte une extension latérale (30) formant une grille pour le transistor à effet de champ,
ledit dispositif comprenant en outre une région périphérique (36) fortement dopée du premier type de conductivité, entourant au moins partiellement et à une certaine distance, l'ensemble de la zone de base (28) et de son extension latérale (30),
caractérisé en ce que l'extension latérale (30) de la zone de base comporte une ouverture (38) dans laquelle est située une région de drain (40) pour le transistor à effet de champ, qui est fortement dopée du premier type de conductivité, qui est entièrement entourée par ladite extension latérale (30) et séparée de celle-ci par une distance latérale déterminée (w), et en ce que la région de couche enterrée (34), étant de forme allongée, s'étend longitudinalement au-delà de l'ensemble de la zone de base et de son extension latérale jusqu'à être recouverte par ladite région périphérique (36), cette dernière région formant avec la région de couche enterrée (34) la source du transistor à effet de champ (12).

2. Dispositif selon la revendication 1, caractérisé en ce que l'extension latérale (30) de la zone de base est bordée par une région adjacente (42) de même type de conductivité et plus faiblement dopée, le long du bord de l'ouverture (38) comprenant la région de drain (40).

3. Dispositif selon la revendication 2, caractérisé en ce que l'épaisseur de la couche épitaxiale (20) et la concentration de dopage de cette couche sont choisies de telle sorte que cette couche épitaxiale, dans une région avoisinant ladite région adjacente (42) plus faiblement dopée, soit entièrement désertée de porteurs de charge pour une tension déterminée appliquée à la jonction formée entre la région de drain (40) et la grille (30) du transistor à effet de champ (12), tension déterminée qui est inférieure à la tension de claquage de cette jonction.

4. Dispositif selon l'une des revendications 2 ou 3,
caractérisé en ce qu'il comporte successivement au-dessus de la surface du dispositif,
une première couche isolante (44),
une première électrode de champ (46) formée d'une couche conductrice en contact avec l'extension latérale (30) de la zone de base à travèrs une première ouverture (48) dans la première couche isolante (44) et qui se prolonge sur la première couche isolante, au dessus de ladite région adjacente (42) plus faiblement dopée, en direction de la région de drain (40) et sur une distance inférieure à la moitié de ladite distance latérale (w),
une première partie (50a) d'une deuxième électrode de champ, conductrice, en contact avec la région de drain (40) à travers une deuxième ouverture (52) dans la première couche isolante (44) et qui se prolonge latéralement sur la première couche isolante en direction de la première électrode de champ (46), sur une distance inférieure à la moitié de ladite distance latérale (w),
une deuxième couche isolante (54),
et une deuxième partie (50b) de la deuxième électrode de champ, conductrice, en contact avec la première partie (50a) de cette même électrode à travers une ouverture (56) dans la deuxième couche isolante, et qui se prolonge latéralement sur le deuxième couche isolante en direction de la première électrode de champ (46) au moins jusqu'à proximité de cette première électrode.

5. Dispositif selon l'une quelconque des revendications 1 à 4, caractérisé en ce que le transistor à effet de champ (12) est constitué de deux parties, disposées symétriquement par rapport à un axe longitudinal de la région de couche enterrée (34), parties dont les régions homologues (60a, 60b) sont connectées électriquement en parallèle, et en ce que la région périphérique (36) entoure totalement la zone de base et son extension latérale (30).

6. Dispositif selon l'une des revendications 1 à 4, caractérisé en ce que le transistor à effet de champ est constitué d'une pluralité de cellules (12a, 12b, ..., 12i) alignées latéralement par rapport au transistor bipolaire (10), la région périphérique (36) d'une cellule (12b) ayant une partie commune (37) avec celle de la cellule (12a) qui lui est adjacente, et les régions homologues étant connectées entre elles, en parallèle.

## Claims

1. An integrated device formed by the combination of a bipolar transistor (10) and a junction field effect transistor (12), comprising:
a collector zone formed, on the one hand, by a portion (32) of a weakly doped epitaxial layer (20) of the first conductivity type supported by a weakly doped substrate (22) of the second conductivity type, and, on the other hand, by a heavily doped buried layer region (34) of the first conductivity type,
a heavily doped emitter zone (26) of a first conductivity type, extending above the buried layer region (34),
a base zone (28) which is less heavily doped than the emitter zone, which is of a second conductivity type opposed to the first type, in which the emitter zone (26) is included, and which comprises a lateral extension (30) forming a gate for the field effect transistor,
said device in addition comprising a heavily doped peripheral region (36) of the first conductivity type which surrounds the base zone (28) and its lateral extension (30) at least partly and at a certain distance,
characterized in that the lateral extension (30) of the base zone comprises an opening (38) in which a drain region (40) for the field effect transistor is situated, which drain region is heavily doped of the first conductivity type, is completely surrounded by said lateral extension (30) and is separated therefrom by a given lateral distance (w), and in that the buried layer region (34), which is of elongate shape, extends in longitudinal direction to beyond the assembly of the base zone and its lateral extension so as to be covered by said peripheral region (36), this latter region forming together with the buried layer region (34) the source of the field effect transistor (12).

2. A device as claimed in claim 1, characterized in that the lateral extension (30) of the base zone is bounded by an adjacent region (42) of the same conductivity type and more weakly doped along the edge of the opening (38) comprising the drain region (40).

3. A device as claimed in claim 2, characterized in that the thickness of the epitaxial layer (20) and the doping concentration of this layer are chosen to be such that said epitaxial layer, in a region adjoining said adjacent more weakly doped region (42), is completely depleted of charge carriers at a given voltage applied to the junction formed between the drain region (40) and the gate (30) of the field effect transistor (12), which given voltage is lower than the breakdown voltage of said junction.

4. A device as claimed in claim 2 or 3, characterized in that it comprises, in this order, on the surface of the device,
a first insulating layer (44),
a first field electrode (46) formed by a conductive layer in contact with the lateral extension (30) of the base zone through a first opening (48) in the first insulating layer (44) and extending on the first insulating layer over said adjacent more weakly doped region (42), in the direction of the drain region (40) over a distance smaller than half the said lateral distance (w),
a first part (50a) of a second field electrode, conductive and in contact with the drain region (40) through a second opening (52) in the first insulating layer (44), and extending in lateral direction on the first insulating layer in the direction of the first field electrode (46) over a distance smaller than half the said lateral distance (w), a second insulating layer (54),
and a second part (50b) of the second field electrode, conductive and in contact with the first part (50a) of this same electrode through an opening (56) in the second insulating layer, and extending laterally on the second insulating layer in the direction of the first field electrode (46) at least up to close to this first electrode.

5. A device as claimed in any one of claims 1 to 4, characterized in that the field effect transistor (12) is formed by two parts arranged symmetrically relative to a longitudinal axis of the buried layer region (34), of which parts the homologous regions (60a, 60b) are electrically connected in parallel, and in that the peripheral region (36) completely surrounds the base zone and its lateral extension (30).

6. A device as claimed in any one of claims 1 to 4, characterized in that the field effect transistor is formed by a plurality of cells (12a, 12b ... 12i) laterally aligned relative to the bipolar transistor (10), the peripheral region (36) of one cell (12b) having a part (37) in common with that of the cell (12a) adjacent thereto, while the homologous regions are interconnected in parallel with one another.

## Patentansprüche

1. Integrierte Anordnung, die zusammen von einem bipolaren Transistor (10) und einem Feldeffekttransistor (12) mit Übergang gebildet wird und folgendes umfaßt:
eine Kollektorzone, die erstens durch einen Abschnitt (32) einer schwach dotierten, von einem schwach dotierten Substrat (22) mit einem zweiten Leitungstyp getragenen Epitaxialschicht (20) des ersten Leitungstyps gebildet wird, und zweitens durch ein vergrabenes, stark dotiertes Schichtgebiet (34) des ersten Leitungstyps,
eine stark dotierte Emitterzone (26) mit einem ersten Leitungstyp, die unterhalb des vergrabenen Schichtgebiets (34) verläuft,
eine Basiszone (28), die weniger stark dotiert ist als die Emitterzone mit einem zweiten, dem erstgenannten entgegengesetzten Leitungstyp, in die die Emitterzone (26) eingeschlossen ist und die eine seitliche Verlängerung (30) umfaßt, die ein Gate für den Feldeffekttransistor bildet,
wobei die Anordnung ein stark dotiertes Randgebiet (36) des ersten Leitungstyps umfaßt, das wenigstens teilweise und in einem gewissen Abstand die gesamte Basiszone (28) und deren seitliche Verlängerung (30) umgibt,
dadurch gekennzeichnet, daß die seitliche Verlängerung (30) der Basiszone eine Öffnung (38) umfaßt, in der sich ein Drain-Gebiet (40) für den Feldeffekttransistor befindet, das stark dotiert und vom ersten Leitungstyp ist, und das vollständig von der genannten seitlichen Verlängerung (30) umgeben und von dieser durch einen bestimmten seitlichen Abstand (w) getrennt ist, und daß das vergrabene Schichtgebiet (34) mit länglicher Form in Längsrichtung jenseits der gesamten Basiszone und seiner seitlichen Verlängerung verläuft, bis es von dem genannten Randgebiet (36) bedeckt wird, wobei dieses letztgenannte Gebiet mit dem vergrabenen Schichtgebiet (34) die Source des Feldeffekttransistors (12) bildet.

2. Anordnung nach Anspruch 1, dadurch gekennzeichnet, daß die seitliche Verlängerung (30) der Basiszone entlang dem Rand der Öffnung (38), die das Drain-Gebiet (40) enthält, von einem angrenzenden Gebiet (42) mit gleichem Leitungstyp und schwächerer Dotierung eingefaßt wird.

3. Anordnung nach Anspruch 2, dadurch gekennzeichnet, daß die Dicke der Epitaxialschicht (20) und die Dotierungskonzentration dieser Schicht so gewählt sind, daß diese Epitaxialschicht in einem Gebiet, das neben dem genannten schwächer dotierten, angrenzenden Gebiet (42) liegt, bei einer bestimmten Spannung, angelegt an die zwischen dem Drain-Gebiet (40) und dem Gate (30) des Feldeffekttransistors (12) gebildete Verbindung, vollständig von Ladungsträgern frei ist, wobei die bestimmte Spannung niedriger ist als die Durchschlagsspannung dieser Verbindung.

4. Anordnung nach einem der Ansprüche 2 oder 3, dadurch gekennzeichnet, daß sie nacheinander unter der Oberfläche der Anordnung folgendes umfaßt:
eine erste Isolierschicht (44),
eine erste Feldelektrode (46), die von einer ersten Leiterschicht im Kontakt mit der seitlichen Verlängerung (30) der Basiszone durch eine erste Öffnung (48) in der ersten Isolierschicht (44) gebildet wird und die sich auf der zweiten Isolierschicht unterhalb des genannten schwächer dotierten, angrenzenden Gebiets (42) in Richtung des Drain-Gebiets (40) und in einem geringeren Abstand als der Hälfte des genannten seitlichen Abstands (w) fortsetzt,
einen ersten Teil (50a) einer zweiten leitenden Feldelektrode in Kontakt mit dem Drain-Gebiet (40) durch eine zweite Öffnung (52) in der ersten Isolierschicht (44), die sich seitlich auf der ersten Isolierschicht in Richtung der ersten Feldelektrode (46) in einem geringeren Abstand als der Hälfte des genannten seitlichen Abstands (w) fortsetzt,
eine zweite Isolierschicht (54),
und einen zweiten Teil (50b) der zweiten leitenden Feldelektrode in Kontakt mit dem ersten Teil (50a) derselben Elektrode durch eine Öffnung (56) in der zweiten Isolierschicht, der sich seitlich auf der zweiten Isolierschicht in Richtung der ersten Feldelektrode (46) wenigstens bis in die Nähe dieser ersten Elektrode fortsetzt.

5. Anordnung nach einem der Ansprüche 1 bis 4, dadurch gekennzeichnet, daß der Feldeffekttransistor (12) aus zwei Teilen besteht, die symmetrisch zu einer Längsachse des vergrabenen Schichtgebiets (34) angeordnet sind, wobei die homologen Gebiete (60a, 60b) dieses Teils elektrisch parallel verbunden sind, und daß das Randgebiet (36) die Basiszone und ihre seitliche Verlängerung (30) vollständig umgibt.

6. Anordnung nach einem der Ansprüche 1 bis 4, dadurch gekennzeichnet, daß der Feldeffekttransistor aus mehreren, seitlich zum bipolaren Transistor (10) ausgerichteten Zellen (12a, 12b,..., 12i) besteht, wobei das Randgebiet (36) einer Zelle (12b) einen gemeinsamen Teil (37) mit dem der Zelle aufweist, die an sie angrenzt, und die homologen Gebiete untereinander parallel verbunden sind.
